(19) Europäisches Patentamt
European Patent Office
Office européen des brevets

(11) Veröffentlichungsnummer : **0 506 675 B1**

(12) # EUROPÄISCHE PATENTSCHRIFT

(45) Veröffentlichungstag der Patentschrift :
**26.10.94 Patentblatt 94/43**

(51) Int. Cl.$^5$ : **H01L 21/66,** G01R 31/26

(21) Anmeldenummer : **90916707.4**

(22) Anmeldetag : **23.11.90**

(86) Internationale Anmeldenummer :
**PCT/DE90/00899**

(87) Internationale Veröffentlichungsnummer :
**WO 91/10258 11.07.91 Gazette 91/15**

(54) **VERFAHREN ZUR BESTIMMUNG DER LAGE EINES PN-ÜBERGANGS.**

(30) Priorität : **23.12.89 DE 3942861**

(43) Veröffentlichungstag der Anmeldung :
**07.10.92 Patentblatt 92/41**

(45) Bekanntmachung des Hinweises auf die Patenterteilung :
**26.10.94 Patentblatt 94/43**

(84) Benannte Vertragsstaaten :
**DE ES FR GB IT**

(56) Entgegenhaltungen :
**US-A- 3 650 020**
**US-A- 4 863 548**
**PATENT ABSTRACTS OF JAPAN, vol. 12, no. 174 (E-612), 8 December 1987 ; & JP-A-62 282 444**

(56) Entgegenhaltungen :
**PATENT ABSTRACTS OF JAPAN, vol. 10, no. 164 (E-410), 24 January 1986 ; & JP-A-61 16 541**
**PATENT ABSTRACTS OF JAPAN, vol. 9, no. 298 (E-361), 19 July 1985 ; & JP-A-60 136 326**
**PATENT ABSTRACTS OF JAPAN, vol. 9, no. 291 (E-359), 15 July 1985 ; & JP-A-60 132 337**
**PATENT ABSTRACTS OF JAPAN, vol. 9, no. 81 (E-307), 4 December 1984 ; & JP-A-59 214 233**

(73) Patentinhaber : **ROBERT BOSCH GMBH**
**Postfach 30 02 20**
**D-70442 Stuttgart (DE)**

(72) Erfinder : **PLUNTKE, Christian**
**Kammweg 64**
**D-7410 Reutlingen (DE)**
Erfinder : **THIENEL, Christoph**
**Gustav-Schwab-Strasse 47**
**D-7410 Reutlingen (DE)**
Erfinder : **DENNER, Volkmar**
**Im Kühnenbach 72**
**D-7410 Reutlingen (DE)**

**EP 0 506 675 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Stand der Technik

Die Erfindung betrifft ein Verfahren zur Bestimmung der Lage eines pn-Übergangs bzw. der Eindringtiefe der diffundierten Elektrode bei in Planartechnologie erstellten Halbleiter-Bauelementen gemäß der Gattung des Hauptanspruchs.

Es ist erforderlich, innerhalb des Planarprozesses bei der Herstellung von Halbleiterbauteilen die ausgeführten Belegungen und Diffusionen zu kontrollieren. Dazu ist es allgemein üblich, bei jeder Charge eine der einlaufenden Platten als sogenannte Probeplatte nur zur Bestimmung des Oberflächenschichtwiderstandes und der Eindringtiefe zu verwenden.

Dazu wird nach der Diffusion und der Messung des Schichtwiderstandes auf der Probeplatte ein Rillenschliff angefertigt. Nach der Behandlung mit Chemikalien färben sich p- und n-dotierte Bereiche unterschiedlich, so daß der Schliff unter dem Mikroskop vermessen und die Eindringtiefe angenähert berechnet werden kann.

Insbesondere bei höher integrierten Leistungshalbleitern kann es erforderlich sein, mehrere Belegungen und Diffusionen zu kontrollieren. Dies kann bedeuten, daß mehrere Probeplatten mitgeführt und ausgewertet werden müssen. Zudem ist der Umgang mit Chemikalien, wobei insbesondere auch Fluor-Wasserstoff verwendet wird, aufwendig und nicht ungefährlich.

US-A-3 650 020 beschreibt ein Verfahren zur Bestimmung der lateralen und vertikalen Ausdehnung von Diffusionen, d.h. der Lage eines pn-Überganges, bei in Planartechnologie erstellten Halbleiter-Bauelementen, bei dem ein in sich zusammenhängendes, V-förmiges, Diffusionsgebiet darstellendes Testmuster erzeugt wird, das mehrere Paare von Fenstern enthält, durch die die Diffusionsgebiete kontaktiert sind, wobei für jedes Paar von Fenstern eine Widerstandsmessung erfolgt.

Vorteile der Erfindung

Mit dem Verfahren zur Bestimmung der Lage eines pn-Übergangs bzw. der Eindringtiefe der diffundierten Elektrode bei in Planartechnologie erstellten Dioden/Transistoren nach den Merkmalen des Anspruchs 1 wird vorteilhaft erreicht, daß durch die Verwendung von Testmustern die Datensicherheit erhöht wird. Alle Platten einer Charge können mit Bauteilen strukturiert werden, woraus sich im allgemeinen ein Ausbeutezuwachs ergibt. Ein schwer zu handhabender Umgang mit Chemikalien entfällt vollständig. Eine besondere Behandlung von Probeplatten im Lackier- oder Belichtungsschritt entfällt ebenfalls. Mechanische Arbeiten, wie die Anbringung von Rillenschliffen, sind nicht mehr erforderlich. Die Bestimmung der Eindringtiefe läßt sich zudem automatisieren. Die Eindringtiefe läßt sich mit höherer Genauigkeit als bisher bestimmen. Es ist eine ständige Kontrolle der Diffusionen an jedem Ort im Diffusionsrohr möglich.

Zeichnung

Zwei Arten des Verfahrens werden anhand der Zeichnung dargestellt und in der nachfolgenden Beschreibung näher erläutert.

Es zeigen:

Fig. 1 Masken, Dotierprofile und Kennlinien von Fensterpaaren in unterschiedlichen Abständen,
Fig. 2 ein Testmuster mit Oxidstegen,
Fig. 3 eine Spannungsparabel, die den Zusammenhang zwischen der Punch-through-Spannung U und der Ausdehnung 1 der Raumladungszone in dem Material, in das diffundiert wird, wiedergibt,
Fig. 4 die aus der Spannungsparabel nach Fig. 3 durch Potenzieren mit 0,5 gewonnene Gerade.

Das erfindungsgemäße Verfahren verwendet den Zusammenhang zwischen vertikaler und lateraler Eindringtiefe am Maskenrand. Ziel ist es dabei, die seitliche Ausdiffusion bzw. Eindringtiefe $Y_j$ an der Oberfläche zu bestimmen und mit Hilfe der Größe $C = \frac{X_j}{Y_j}$ die vertikale Eindringtiefe $X_j$ zu berechnen.

Dabei wird verwendet, daß sich je nach Dotierungskonzentration $N_b$ des Materials, in das diffundiert wird, nach eingebrachter Dosis $Q_A$ und nach Diffusionskonstante D des Dotierstoffes sowie der Diffusionsdauer $t_D$ ein konstantes Verhältnis C ($N_b$, $Q_A$, D, $t_D$) zwischen vertikaler Eindringtiefe $X_j$ und lateraler Eindringtiefe $Y_j$ einstellt. C kann als Verfahrenskonstante für unterschiedliche Gegebenheiten berechnet werden und wird in einer Korrelation abgesichert.

Zur Bestimmung von $Y_j$ wird im Lithographieschritt vor Belegung mindestens ein Testmuster mit einbelichtet, das N Paare von Fenstern enthält. Dabei soll der Abstand $d_{layout}$ von beiden Fenstern innerhalb eines Paares von Paar zu Paar jeweils um einen vorzugsweise konstanten Betrag $\Delta d$ zunehmen, so daß im ersten Paar (n = I) der kleinste und im letzten Paar (n = N) der größte Abstand vorliegt. Dies ist in Fig. 1 in der linken Spalte dargestellt, wo jeweils Fenster in Masken bzw. Diodenübergänge a und b mit unterschiedlichen Abständen dargestellt sind.

Es gilt somit, falls $\Delta d$ = const:

$$d^{(n)}_{layout} = d^{(I)}_{layout} + (n - I) \cdot \Delta d. \qquad (n = I...N)$$

Wenn die Layoutabstände des Testmusters richtig gewählt wurden, überlappen die beiden lateral aufeinanderzudiffundierenden Wannen beim Paar 1, während sie beim Paar N voneinander getrennt sind (mittlere Spalte in Fig. 1).

Nach Belegung, Diffusion und evtl. erneutem Öffnen der Fenster des Testmusters im nachfolgenden Lithographieschritt, kann durch Kontaktieren in den Öffnungen jeweils eines Paares der elektrische Widerstand zwischen den Öffnungen gemessen werden.

Man mißt am Paar 1 eine ohmsche Widerstandsgerade und am Paar N die Punch-through-Spannung der Diode b, die in Sperrichtung betrieben wird. Vorteilhaft wird bei dieser Messung die Diode a kurzgeschlossen, so daß keine Lateral-Transistoreffekte zusätzlich auftreten.

Zwischen den Fensterpaaren 1 und N gibt es ein Paar $n_0$, bei dem sich die beiden Wannen gerade eben noch berühren. Das heißt, beim Paar $n_0$-I tritt bereits eine Überlappung ein, während beim Paar $n_0$+I die leitende Verbindung zwischen beiden Wannen erst durch Punch-through der Raumladungszone des sperrenden pn-Übergangs an der anderen Wanne ermöglicht wird.

Das Paar $n_0$ kann durch Analyse des Strom-Spannungs-Zusammenhangs aller Fensterpaare leicht gefunden werden. Wie aus der dritten Spalte der Fig. 1 ersichtlich, ergibt sich bis zum Fensterpaar $n_0$ ein linearer, ohmscher Zusammenhang zwischen Strom und Spannung. In einem darüberliegenden Bereich mit $n > n_0$ wird der Strom-Spannungs-Zusammenhang nichtlinear, woraus das Paar $n_0$ ermittelt werden kann.

Damit kann die Größe $d^{(n_0)}{}_{layout}$ ermittelt werden. Diese Größe entspricht aber wegen der Unterätzung des Fotolacks nicht der effektiv wirksamen Größe $d^{(n_0)}{}_{eff}$, sondern muß um die doppelte Unterätzung pro Oxidkante $d_u$ korrigiert werden. Damit gilt der Zusammenhang:

$$d_{eff}{}^{(n_0)} = d^{(n_0)}_{layout} - 2\, d_u.$$

Zur Ermittlung von $d_u$ ist im Testmuster eine Anzahl K dunkler Felder vorgesehen, so daß im Positivprozeß eine Reihe von Oxidstegen entsteht, wie dies in Fig. 2 in der linken Spalte dargestellt ist. Die Breite dieser Felder $b^{(k)}{}_{layout}$ nimmt von Feld zu Feld um einen vorzugsweise konstanten Betrag $\Delta b$ zu. Für die Breite der Felder gilt also, falls $\Delta b$ = const:

$$b^{(k)}_{layout} = b^{(I)}_{layout} + (k - I) \cdot \Delta b. \qquad (k = I...K)$$

Bei einer geeigneten Wahl der Breite der Felder $b^{(k)}{}_{layout}$ und der richtigen Anzahl K der Felder, bewirkt die Unterätzung, daß die schmalsten $k_0$ Oxidstege gerade weggeätzt werden und vom Steg $k_0$ + I Ätzreste übrigbleiben. Bei allen breiteren Stegen mit $k > k_0 + I$ sind mindestens deutliche Oxidkanten vorhanden, wobei $I < k_0 < K$ ist.

Durch Abzählen der übriggebliebenen K - $k_0$ Oxidstege kann $k_0$ und damit die Unterätzung bestimmt werden:

$$b^{(k_0)}_{layout} = 2\, d_u.$$

Damit läßt sich die seitliche Eindringtiefe eines pn-Übergangs $Y_j = \frac{d_{eff}}{2}$ und hieraus mit $C = \frac{X_j}{Y_j}$ die vertikale Eindringtiefe $X_j$ bestimmen.

Zusammengefaßt gilt, falls $\Delta d = \Delta b$ gewählt wird:

$$Y_j = \frac{I}{2} \cdot (d^{(I)}_{layout} - b^{(I)}_{layout} + (n_0 - k_0) \cdot \Delta d) \qquad (I)$$

$$X_j = C\,(N_b, Q_A, D, t_D) \cdot Y_j \qquad (II).$$

Zur Bestimmung der vertikalen Eindringtiefe muß lediglich $n_0$ und $k_0$ durch Messen und Abzählen erfaßt und eingesetzt werden.

Beim vorstehend beschriebenen Verfahren wird $n_0$ über die Auswertung einer Widerstandsmessung bzw. der Kennlinien über alle Fensterpaare bestimmt. Mit der nachfolgend, im Zusammenhang mit den Fig. 3 und 4 beschriebenen, weiteren Ausgestaltung des Verfahrens besteht die Möglichkeit, das Testmuster deutlich zu verkleinern und dabei gleichzeitig die Bestimmung der Lage des pn-Übergangs noch zu vereinfachen und zu präzisieren.

Im Testmuster kann durch Messen an den Fensterpaaren der Zusammenhang zwischen dem Index n und der Sperrspannung $U_{sp}$ an der Diode in Sperrichtung ermittelt werden, wobei sich der gesamte Verlauf der Sperrspannung $U_{sp}$ in Abhängigkeit von n in drei Abschnitte einteilen läßt. Der Meßstrom $J_0$ soll dabei konstant

sein. Diese drei Abschnitte sind mit den römischen Ziffern I, II und III in Fig. 3 eingezeichnet.

Der Abschnitt I betrifft den Bereich $I \leqq n \leqq n_0$. Dort sind die eindiffundierten Wannen miteinander verbunden und es gibt kein Punch-through. Die Spannungswerte sind dort klein und nahezu konstant.

Der Abschnitt II betrifft den Bereich $n_0 < n < n'$. Die Wannen sind hier getrennt und es tritt Punch-through auf. In diesem Bereich nimmt mit steigendem n die Spannung $U_{sp}$ zu.

Der dritte Abschnitt III betrifft den Bereich $n' \leqq n \leqq N$. Die Wannen sind dort getrennt und soweit voneinander entfernt, daß kein Punch-through mehr stattfinden kann. Der Durchbruch findet an der Oberfläche statt. Daher ist die gemessene Spannung $U_{sp}$ unabhängig von n.

Gesucht wird die genaue Lage des Übergangs vom Abschnitt I zum Abschnitt II, wobei diese Lage der wahren lateralen Eindringtiefe $Y_{j0}$ entspricht. Bei der Ermittlung der Punch-through-Spannung in Abhängigkeit der Ausdehnung $\ell$ der Raumladungszone in dem Material, in das diffundiert wird, im Bereich II stellt sich heraus, daß eine Parabel den Zusammenhang für einen weiten Bereich planar erstellter pn-Übergänge optimal beschreibt, das heißt, es gilt im Bereich II:

$$U \propto \ell^2 \text{ oder } \ell \propto U^{1/2}.$$

Dieser Zusammenhang ist in Fig. 3 als Abhängigkeit der Sperrspannung $U_{sp}$ an der Diode b vom Index n bzw. von der Ausdehnung $\ell$ der Raumladungszone im Bereich II eingezeichnet.

Die mit 0,5 potenzierten U-Werte im Bereich II liegen auf einer Geraden mit dem gesuchten Achsenabschnitt $n_0^*$ und der Steigung

$$m = \frac{\Delta\sqrt{U}}{\Delta n}.$$

Diese Gerade kann aus zwei Messungen auf der Spannungsparabel (Fig. 3) bestimmt werden. Zwei solche Meßpunkte sind beispielsweise in Fig. 4 eingezeichnet, aus denen die Steigung m und die Lage des entsprechenden Geradenabschnitts ermittelt wurde. Durch Verlängerung der Geraden wird der Null-Durchgang an der Stelle $n_0^*$ erhalten. Zur Bestimmung von $Y_{j0}$ setzt man die im allgemeinen nicht natürliche Zahl $n_0^*$ in Gleichung (I) anstelle von $n_0$ ein. Die Unempfindlichkeit gegen Meßeinflüsse wird jedoch größer, je mehr Meßpunkte für die $Y_{j0}$-Bestimmung herangezogen werden. Diese Art der $Y_{jo}$-Bestimmung liefert den Wert der wahren, lateralen Eindringtiefe $Y_{j0}$ prinzipiell exakter als die Messung aus der vorstehend beschriebenen Methode. Dort wird der Index $n_0$ desjenigen Fensterpaares ermittelt, wo zum letzten Mal eine ohmsche Verbindung zwischen den eindiffundierten Wannen besteht. Das bedeutet aber, daß die wahre, laterale Eindringtiefe zwischen den Indizes $n_0$ und $n_0$+I liegen muß. Diese Stelle ist für die Messung nach der ersten Methode nicht zugänglich, wohl aber durch die zweite Methode durch Anfitten der Spannungsparabel.

Die Steigung m der Geraden gibt Auskunft über die Dotierungskonzentration $N_b$ oder den spezifischen Widerstand $\rho$ des Materials, in das eindiffundiert wird. Die Steigung m beschreibt die Öffnung der Spannungsparabel und ist umso kleiner, je kleiner $N_b$ wird bzw. je größer der spezifische Widerstand $\rho$ ist. Mit Hilfe der Steigung m kann somit die Dotieruncskonzentration $N_b$ bzw. der spezifische Widerstand $\rho$ abgeschätzt werden, sofern diese Größen in einer Korrelation zugeordnet wurden.

Mit der vorliegenden Bestimmungsmethode könnte theoretisch das Testmuster bis auf zwei Fensterpaare reduziert werden. Bei der vorstehend genannten Korrektur um die doppelte Unterätzung ($2 \cdot d_u$) müssen in der Praxis so viele Fensterpaare vorgesehen sein, daß bei allen auftretenden $k_0$-Werten mindestens zwei Messungen auf der Spannungsparabel möglich sind.

**Patentansprüche**

1. Verfahren zur Bestimmung der lateralen und der vertikalen Eindringtiefe von in das Halbleitermaterial durch Eindiffundieren eines Dotierstoffs eingebrachten, gegen das Halbleitermaterial jeweils einen pn-Übergang bildenden Wannen bei in Planartechnologie erstellten Halbleiterbauelementen, wobei auf dem Halbleitermaterial eine Maske mit Fenstern gebildet und der Dotierstoff zur Ausbildung der Wannen durch die Fenster in der Halbleitermaterial eindiffundiert wird und wobei ferner gleichzeitig mit der Eindiffusion der genannten Wannen ein Testmuster in das Halbleitermaterial miteingebracht wird, dadurch gekennzeichnet, daß das Testmuster N Paare von weiteren, durch denselben Dotierstoff gebildeten Wannen und N Paare von Fenstern enthält, durch die der Dotierstoff zur Ausbildung der weiteren Wannen eingebracht wird und die so angeordnet werden, daß der Abstand der beiden Fenster eines Paares von Paar zu Paar zunimmt, so daß im ersten Paar (n = 1) der kleinste und im letzten Paar (n = N) der größte Abstand vorliegt, daß der Abstand der Fensterpaare so gewählt wird, daß die beim Planarprozeß entstehenden Wannen beim ersten Fensterpaar (n = 1) überlappen und beim letzten Fensterpaar (n = N) voneinander getrennt sind, so daß dazwischen ein Fensterpaar liegt ($n = n_0$), bei dem sich die beiden Wannen angenähert gerade noch berühren, daß nach Erstellung des pn-Übergangs durch Kontaktieren in den Fenstern jeweils

eines Paares die Strom-Spannungs-Charakteristik gemessen wird und mit Hilfe dieser Messung dasjenige Fensterpaar ($n = n_0$) ermittelt wird, bei dem sich die Wannen gerade noch berühren, und daß daraus die laterale Eindringtiefe ($Y_j$) als halber Abstand (d) der Fenster des Paares ($n = n_0$)

$$Y_j = \frac{d}{2}$$

und daraus die vertikale Eindringtiefe ($X_j$) über die Beziehung

$$X_j = C \cdot Y_j$$

ermittelt wird, wobei C das Verhältnis zwischen der lateralen Eindringtiefe ($Y_j$) und der vertikalen Eindringtiefe ($X_j$) beschreibt, wobei sich bei Fensterpaaren ($n \leqq n_0$) mit kleineren Abständen die Wannen überlappen bzw. sich berühren und dadurch ein Widerstandsverhalten mit linearem Strom-Spannungs-Zusammenhang vorliegt und bei Fensterpaaren ($n > n_0$) mit größeren Abständen die leitende Verbindung zwischen den Wannen erst durch punch-through der Raumladungszone des sperrenden pn-Übergangs zu der anderen Wanne möglich wird mit einem nichtlinearen Strom-Spannungs-Zusammenhang, so daß der Übergang vom linearen zum nicht-linearen Strom-Spannungs-Zusammenhang das Fensterpaar ($n = n_0$) bestimmt.

2. Verfahren nach Anspruch 1, dadurch gekennzeichnet, daß der Abstand der beiden Fenster eines Paares von Paar zu Paar um einen konstanten Betrag $\Delta d$ zunimmt, so daß gilt:

$$d^{(n)} = d^{(1)} + (n - 1) \cdot \Delta d \qquad (n = 1 \ldots N).$$

3. Verfahren nach Anspruch 1, dadurch gekennzeichnet, daß die genaue Lage des Übergangs gefunden wird, bei dem sich aufgrund der vorliegenden, wahren lateralen Eindringtiefe ($Y_{j0}$) die Wannen des entsprechenden Fensterpaares gerade noch berühren würden, wobei diese Lage zwischen den Werten aus den Fensterpaaren ($n_0$) und ($n_0 + 1$) liegt mit

$$Y_j = \frac{d^{(n_0)}}{2} \leqq Y_{j0} < \frac{d^{(n_0+1)}}{2},$$

indem ein Zusammenhang zwischen punch-through-Spannung U und der Ausdehnung $\ell$ der Raumladungszone in dem Material, in das diffundiert wird, verwendet wird mit

$$U \sim \ell^{\alpha} \text{ bzw. } \ell \sim U^{1/\alpha},$$

durch wenigstens drei Messungen und Potenzieren der Spannungswerte mit $1/\alpha$ ein Geradenstück in einem Diagramm $U^{1/\alpha}$ über dem zunehmenden Fensterpaarindex (n) mit der Steigung

$$m = \frac{\Delta (U^{1/\alpha})}{\Delta n}$$

ermittelt wird und dieses Geradenstück bis zum Null-Durchgang ($U^{1/\alpha} = 0$) verlängert wird, wobei sich aus der Lage dieses Null-Durchgangs die wahre Größe der lateralen Eindringtiefe ($Y_{j0}$) bestimmen läßt.

4. Verfahren nach Anspruch 3, dadurch gekennzeichnet, daß an einem Fensterpaar die punch-through-Spannung einer Diode (b), die in Sperrichtung betrieben wird, gemessen wird und die andere Diode (a) in dieser Zeit kurzgeschlossen wird.

5. Verfahren nach Anspruch 3 oder 4, dadurch gekennzeichnet, daß der Zusammenhang zwischen der Sperrspannung $U_{sp}$ an der in Sperrichtung betriebenen Diode (b) und der Ausdehnung $\ell$ der Raumladungszone an der genannten Diode (b) dazu verwendet wird, die Dotierung $N_b$ des Materials, in das diffundiert wird, zu bestimmen, denn es gilt:

$$\ell = C_0 \cdot (U_{sp}/N_b)^{1/\alpha}, \qquad C_0 = \text{const.}$$

$$\longrightarrow N_b^{1/\alpha} = C_1 \cdot \Delta (U_{sp}^{1/\alpha}) / \Delta n = C_1 \; m,$$
$$C_1 = C_0 / \Delta d$$

$$\longrightarrow N_b = (C_1 \cdot m)^{\alpha},$$

wobei

$\alpha$ und m bekannt sind und $C_1$ in einer Korrelation ermittelt wird.

6. Verfahren nach Anspruch 1, dadurch gekennzeichnet, daß der Strom-Spannungs-Zusammenhang an Fensterpaaren mit überlappenden Wannen ($n \leqq n_0$) ermittelt wird, daß der Übergang vom linearen zum nichtlinearen Strom-Spannungs-Zusammenhang dadurch gefunden wird, daß im Bereich ($n \leqq n_0$) die Abhängigkeit des Widerstands vom Fensterabstand analysiert wird und damit auf denjenigen Fensterabstand geschlossen wird, bei dem sich die Wannen gerade noch berühren, und daß damit die wahre laterale Eindringtiefe ($Y_{j0}$) bestimmt wird.

7. Verfahren nach einem der Ansprüche 1 bis 6, dadurch gekennzeichnet, daß die über die elektrische Messung ermittelte Abstandsgröße (d) bzw. die daraus ermittelte laterale Eindringtiefe ($Y_j$) um die Differenz $2\,d_u$, die doppelte Unterätzung pro Oxidkante, zwischen Layoutmaß und Ätzmaß auf die effektiv wirksame Abstandsgröße $d_{eff}$ korrigiert wird, so daß gilt:

$$d_{eff}^{(n0)} = d_{layout}^{(n0)} - 2d_u.$$

8. Verfahren nach Anspruch 7, dadurch gekennzeichnet, daß $d_u$ dadurch erhalten wird, daß im Testmuster eine Anzahl (K) von Feldern der Breite

$$b_{layout}^{(k)}, \qquad (k = 1 \ldots K)$$

so vorgesehen wird, daß im Planarprozeß eine Reihe von Oxidstegen unterschiedlicher Breite entsteht, die vorzugsweise so angeordnet werden, daß die Stegbreite von Oxidsteg zu Oxidsteg zunimmt, daß durch die im Planarprozeß entstehende Differenz zwischen Layout- und Ätzmaß die schmaleren Oxidstege ($k = 1$ bis $k = k_0$, mit $1 \leqq k_0 \leqq K$) verschwinden, so daß nur die breiteren Oxidstege ($k \geqq k_0 + 1$) übrigbleiben, daß durch Abzählen der vorhandenen Oxidstege $k_0$ bestimmt und die Differenz zwischen Layout- und Ätzmaß ermittelt wird zu:

$$d_u = \frac{1}{2} \cdot b_{layout}^{(k0)}.$$

9. Verfahren nach Anspruch 8, dadurch gekennzeichnet, daß die Breite der Felder von Feld zu Feld um einen konstanten Betrag $\Delta b$ zunimmt, so daß gilt:

$$b_{layout}^{(k)} = b_{layout}^{(1)} + (k - 1) \cdot \Delta b \qquad (k = 1 \ldots K).$$

## Claims

1. Method of determining the lateral and vertical depth of penetration of tubs made in the semiconductor material by indiffusion of a dopant, respectively forming a p-n junction against the semiconductor material, in the case of semiconductor devices produced by planar technology, a mask with windows being formed on the semiconductor material and the dopant for forming the tubs being diffused in through the windows in the semiconductor material and, furthermore, at the same time as the indiffusion of the said tubs, a test pattern being incorporated in the semiconductor material, characterised in that the test pattern contains N pairs of further tubs, formed by the same dopant, and N pairs of windows, through which the dopant for forming the further tubs is introduced and which are arranged such that the spacing of the two windows of a pair increases from pair to pair, so that in the first pair ($n = 1$) there is the smallest spacing and in the last pair ($n = N$) there is the greatest spacing, in that the spacing of the pairs of windows is chosen such that the tubs produced in the planar process overlap in the first pair of windows ($n = 1$) and are separate from each other in the last pair of windows ($n = N$), so that in between there lies a pair of windows ($n = n_0$) in which the two tubs are approximately still just touching, in that, after producing the p-n junction, the current-voltage characteristic is measured by contacting in the windows of in each case one pair and, with the aid of this measurement, that pair of windows ($n = n_0$) in which the tubs are still just touching is established, and in that from this the lateral depth of penetration ($Y_j$) is established as half the spacing (d) of the windows of the pair ($n = n_0$)

$$Y_j = \frac{d}{2}$$

and from this the vertical depth of penetration ($X_j$) is established by means of the relationship

$$X_j = C \cdot Y_j$$

where C describes the relationship between the lateral depth of penetration ($Y_j$) and the vertical depth of penetration ($X_j$), in which method the tubs overlap, or touch in pairs of windows ($n \leqq n_0$) having relatively small spacings and, as a result, there is a resistance behaviour with a linear current-voltage relationship, and the conducting connection between the tubs in pairs of windows ($n > n_0$) having relatively great spacings only being possible by punch-through of the space-charge zone of the blocking p-n junction to the

other tub, with a non-linear current-voltage relationship, so that the transition from the linear to the non-linear current-voltage relationship determines the pair of windows ($n = n_0$).

2. Method according to Claim 1, characterised in that the spacing of the two windows of a pair increases from pair to pair by a constant amount $\Delta d$, so that the following applies:

$$d^{(n)} = d^{(1)} + (n - 1) \cdot \Delta d \qquad (n = 1 \ldots N).$$

3. Method according to Claim 1, characterised in that the exact position is found of the junction at which, on the basis of the given, true lateral depth of penetration ($Y_{j0}$), the tubs of the corresponding pair of windows would be still just touching, this position lying between the values from the pairs of windows ($n_0$) and ($n_0 + 1$), with

$$Y_j = \frac{d^{(n_0)}}{2} \leqq Y_{j0} < \frac{d^{(n_0+1)}}{2}$$

by using a relationship between punch-through voltage U and the extent $\ell$ of the space-charge zone in the material which is diffused into, with

$$U \sim \ell^{\alpha} \text{ or } \ell \sim U^{1/\alpha},$$

establishing a line section by at least three measurements and raising the voltage values to the power of $1/\alpha$ in a diagram $U^{1/\alpha}$ over the increasing window pair index (n) with the slope

$$m = \frac{\Delta (U^{1/\alpha})}{\Delta n}$$

and extending this line section to the zero crossing ($U^{1/\alpha} = 0$), it being possible to determine from the position of this zero crossing the true value of the lateral depth of penetration ($Y_{j0}$).

4. Method according to Claim 3, characterised in that, at a pair of windows, the punch-through voltage of a diode (b), which is operated in reverse direction, is measured and the other diode (a) is short-circuited during this time.

5. Method according to Claim 3 or 4, characterised in that the relationship between the reverse voltage $U_{sp}$ across the diode (b) operated in reverse direction and the extent $\ell$ of the space-charge zone at the said diode (b) is used to determine the doping $N_b$ of the material which is diffused into, since the following applies:

$$\ell = C_0 \cdot (U_{sp}/N_b)^{1/\alpha}, \qquad C_0 = \text{const.}$$

$$\rightarrow N_b^{\ 1/\alpha} = C_1 \cdot \Delta (U_{sp}^{\ 1/\alpha}) \ / \ \Delta n = C_1\ m,$$

$$C_1 = C_0/\Delta d$$

$$\rightarrow N_b = (C_1 \cdot m)^{\alpha},$$

where
$\alpha$ and m are known and $C_1$ is established in a correlation.

6. Method according to Claim 1, characterised in that the current-voltage relationship is established at pairs of windows having overlapping tubs ($n \leqq n_0$), in that the transition from the linear to the non-linear current-voltage relationship is found, in that the dependence of the resistance on the window spacing is analysed in the range ($n \leqq n_0$) and a conclusion is consequently drawn as to that window spacing at which the tubs are still just touching and in that consequently the true lateral depth of penetration ($Y_{j0}$) is determined.

7. Method according to one of Claims 1 to 6, characterised in that the spacing value (d) established by means of the electrical measurement or the lateral depth of penetration ($Y_j$) established from it is corrected by the difference $2\,d_u$, twice the under-cutting per oxide edge, between layout dimension and etching dimension to the effectively acting spacing value $d_{eff}$, so that the following applies:

$$d_{eff}^{(n0)} = d_{layout}^{\ (n0)} - 2d_u.$$

8. Method according to Claim 7, characterised in that $d_u$ is obtained by there being provided in the test pattern a number (K) of fields of the width

$$b_{layout}^{(k)}, \qquad (k = 1 \ldots K)$$

such that, in the planar process, a series of oxide webs of different widths are produced, which are preferably arranged such that the web width increases from oxide web to oxide web, that the difference between layout dimension and etching dimension arising in the planar process causes the narrower oxide webs ($k = 1$ to $k = k_0$, with $1 \leqq k_0 \leqq K$) to disappear, so that only the wider oxide webs ($k \geqq k_0 + 1$) are left, and that $k_0$ is determined by counting off the existing oxide webs and the difference between layout dimension and etching dimension is established as:

$$d_u = \frac{1}{2} \cdot b_{layout}^{(k0)}.$$

9. Method according to Claim 8, characterised in that the width of the fields increases from field to field by a constant amount $\Delta b$, so that the following applies:

$$b_{layout}^{(k)} = b_{layout}^{(1)} + (k - 1) \cdot \Delta b \qquad (k = 1...K).$$

## Revendications

1. Procédé pour la détermination et la profondeur de pénétration latérale et verticale d'un matériau semi-conducteur, par diffusion d'un produit de dopage, pour des cuvettes qui forment chaque fois une jonction pn par rapport au matériau semi-conducteur, pour des composants semi-conducteurs fabriqués en technique planaire, en formant un masque avec des fenêtres sur le matériau semiconducteur et en diffusant le produit de dopage pour former des cuvettes, à travers les fenêtres dans la matière semiconductrice, tout en réalisant avec la diffusion des cuvettes, un modèle d'essai dans le matériau semi-conducteur, procédé caractérisé en ce que le modèle d'essai est formé par N paires d'autres cuvettes réalisées avec le même produit de dopage et de N paires de fenêtres à travers lesquelles on introduit la matière de dopage pour former les autres cuvettes et on les dispose pour que la distance des deux fenêtres d'une paire augmente d'une paire à l'autre, pour avoir pour la première paire ($n = 1$) le plus petit écart et pour la dernière paire ($n = N$) le plus grand écart, on choisit l'écart des paires de fenêtres pour que les cuvettes formées par le procédé planaire pour la première paire de fenêtres ($n = 1$) se chevauchent et que pour la dernière paire de fenêtres ($n = N$), elles soient séparées, et pour que dans l'intervalle il y ait une paire de fenêtres ($n = n_0$) pour laquelle les cuvettes se touchent à peine, pour qu'après établissement de la jonction pn, par mise en contact sur les fenêtres, on mesure chaque fois une paire de caractéristiques intensité/tension et on détermine à partir de celles-ci la paire de fenêtres ($n = n_0$) respectives pour laquelle les cuvettes se touchent à peine et partant de là on définit la profondeur latérale de pénétration ($Y_j$) comme demi distance (d) des fenêtres de la paire ($n = n_0$) :

$$Y_j = \frac{d}{2}$$

et on en déduit la profondeur verticale de pénétration ($X_j$) par la relation :

$$X_j = C \,.\, Y_j$$

C représentant le rapport entre la profondeur de pénétration latérale ($Y_j$) et la profondeur de pénétration verticale ($X_j$), les paires de fenêtres ($n \leqq n_0$) avec les plus petits intervalles entre les cuvettes se chevauchent ou se touchent et donnent ainsi un comportement résistant à relation linéaire intensité/tension pour les paires de fenêtres ($n > n_0$) correspondant aux intervalles plus grands, la liaison conductrice entre les cuvettes ne devient possible que par le claquage de la zone de charges d'espace de la jonction de blocage pn vers l'autre cuvette, avec une relation intensité/tension non linéaire, si bien que le passage de la relation linéaire à la relation non linéaire entre l'intensité et la tension définit la paire de fenêtres ($n = n_0$).

2. Procédé selon la revendication 1, caractérisé en ce que l'intervalle des deux fenêtres d'une paire augmente d'une paire à l'autre d'une valeur constante $\Delta d$ selon la formule :

$$d^{(n)} = d^{(1)} + (n - 1) \,.\Delta d \qquad (n = 1 \ldots N)$$

3. Procédé selon la revendication 1, caractérisé en ce que pour trouver la position précise de la jonction pour laquelle selon la profondeur de pénétration latérale, réelle ($Y_{j0}$) existante, les cuvettes des paires de fenêtres se toucheraient encore juste, cette position se situe entre les valeurs des paires de fenêtres ($n_0$) et ($n_0 + 1$), se définit par la relation :

$$Y_j = \frac{d^{(n_0)}}{2} \leqq Y_{JO} < \frac{D^{(n_0 + 1)}}{2}$$

en ce qu'on utilise une relation entre la tension de claquage U et l'extension $\ell$ de la zone de charges

d'espace du matériau dans lequel on diffuse avec :

$$U \sim \ell^{\alpha} I \,;\ \ell \sim U^{1/\alpha}$$

par au moins trois mesures et élévation à la puissance de la valeur de la tension selon la puissance $1/\alpha$, qui donne un diagramme $U^{1/\alpha}$ pour l'indice (n) de la pente :

$$m = \frac{\Delta\,(U^{1/\alpha})}{\Delta n}$$

et on prolonge ce segment de droite jusqu'à l'intersection par zéro $(U^{1/\alpha}) = 0$ pour ce passage par zéro, on règle la commande et la profondeur de pénétration latérale $(Y_{j0})$.

**4.** Procédé selon la revendication 3, caractérisé en ce que sur une paire de fenêtres, on mesure la tension de claquage d'une diode (b) qui travaille dans le sens du blocage et pendant ce temps, on court-circuite l'autre diode (a).

**5.** Procédé selon la revendication 3 ou 4, caractérisé en ce qu'on utilise la relation entre la tension de blocage $(U_{sp})$ sur la diode (b) travaillant dans le sens du blocage et l'extension 1 de la zone des charges d'espace sur cette diode (b) pour déterminer le dopage $N_b$ du matériau dans lequel on diffuse en utilisant les relations suivantes :

$$\ell = C_0 \;.\; (U_{sp}/N_b)^{1/\alpha},\quad C_0 = \text{const.}$$

$$\rightarrow\quad N_b^{1/\alpha} = C_1 \;.\; \Delta\,(U_{sp}^{1/\alpha}) \;/\; \Delta n = C_1\ m,$$

$$C_1 = C_0/\Delta d$$

$$\rightarrow\quad N_b = (C_1 \;.\; m)^{\alpha}$$

dans laquelle

$\alpha$ et m sont connus ; $C_1$ utilise une corrélation.

**6.** Procédé selon la revendication 1, caractérisé en ce qu'on détermine la relation intensité/tension pour une paire de fenêtres avec des cuvettes qui se chevauchent $(n \leqq n_0)$ et on trouve le passage entre l'état linéaire et l'état non linéaire de la relation intensité/tension en ce que dans la zone $(n \leqq n_0)$, on analyse la relation entre la résistance et l'écartement des fenêtres et on retient l'écartement des fenêtres pour lequel les cuvettes se touchent encore à peine et on utilise pour définir la profondeur de pénétration latérale réelle $(Y_{j0})$.

**7.** Procédé selon l'une des revendications 1 à 6, caractérisé en ce que l'on corrige la grandeur de l'écart (d) résultant de la mesure électrique ou la profondeur de pénétration $Y_j$ qui en est déduite, par la différence $2\,d_u$, c'est-à-dire le double de l'attaque chimique en contre dépouille par arête d'oxyde, entre la mesure de la disposition et la grandeur d'écartement effective, efficace, $d_{eff}$ dans la relation donnant :

$$d_{eff}^{(n0)} = d_{disposition}^{(n0)} - 2d_u.$$

**8.** Procédé selon la revendication 7, caractérisé en ce qu'on obtient $d_u$ en prévoyant dans le modèle d'essai un nombre (K) de champs de largeur :

$$b_{disposition}^{(k)}, \qquad (K = 1 \ldots K)$$

selon le procédé planaire, on forme une série d'arêtes d'oxyde, de largeurs différentes qui sont prévues de préférence pour que la largeur de l'arête augmente d'une arête d'oxyde à l'autre, et pour que la différence entre la disposition d'attaque chimique selon le profilé planaire entre la mesure de la disposition et celle de l'attaque fasse disparaître les arêtes d'oxyde les plus étroites ($k = 1$ jusqu'à $k = k_0$, $1 \leqq k_0 \leqq K$) et que seules subsistent les arêtes d'oxyde, larges $(k \geqq k_0 + 1)$, et par le comptage des arêtes d'oxyde existant, on définit $k_0$ et on détermine la différence entre la mesure de la disposition et de la mesure, la disposition et celle de l'attaque chimique selon la formule :

$$d_u = \frac{1}{2} \,.\, b_{disposition}\,(k0)$$

**9.** Procédé selon la revendication 8, caractérisé en ce que la largeur des champs augmente d'un champ à l'autre d'une valeur constante $\Delta b$ selon la relation :

$$b_{disposition}^{(k)} = b_{disposition}^{(1)} + (k - 1) \,.\, \Delta b \qquad (k = 1 \ldots K).$$

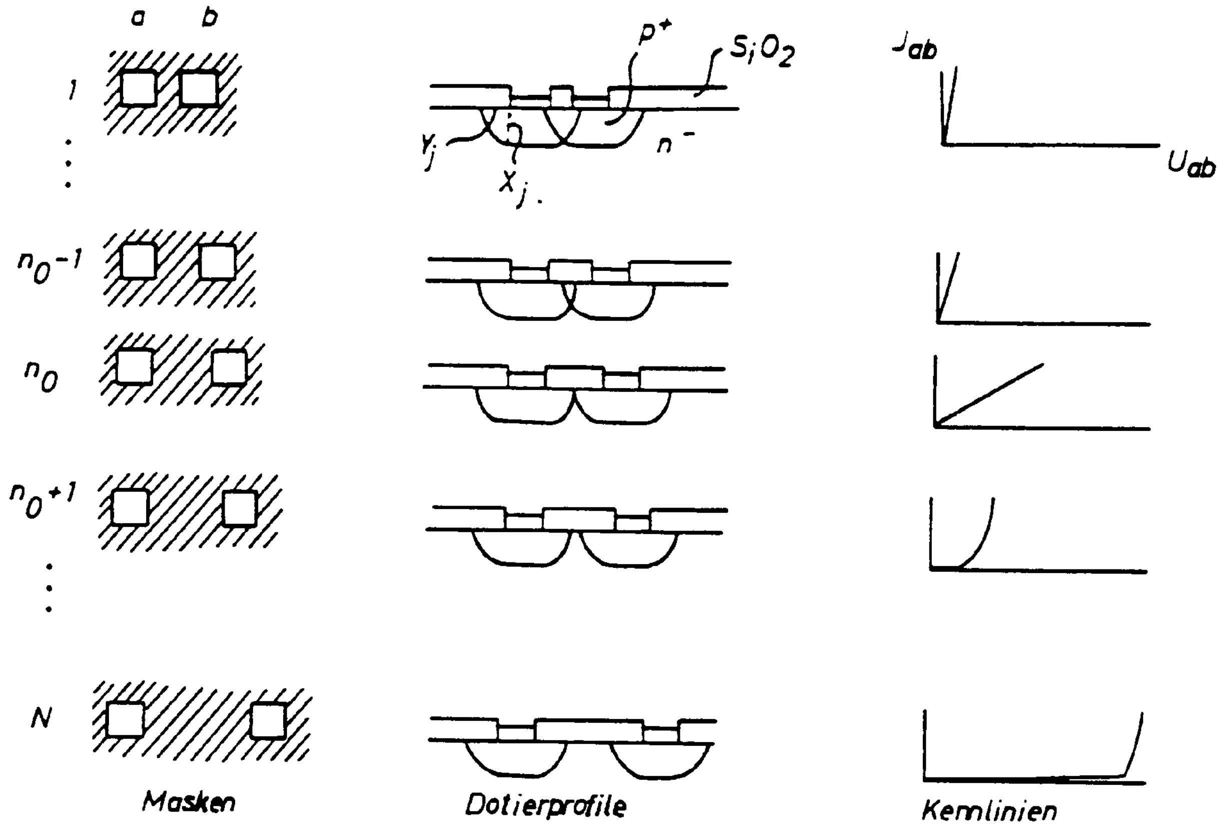
a
b
1
$n_0-1$
$n_0$
$n_0+1$
N
$p^+$
$S_iO_2$
$y_j$
$x_j$.
$n^-$
$J_{ab}$
$U_{ab}$
Masken
Dotierprofile
Kennlinien

FIG. 1

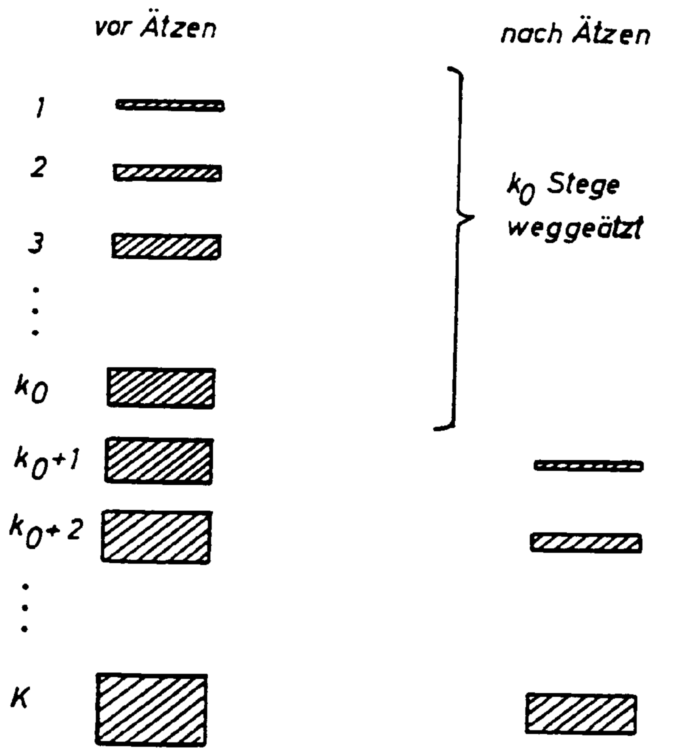
vor Ätzen
nach Ätzen
1
2
3
$k_0$
$k_0+1$
$k_0+2$
K
$k_0$ Stege weggeätzt

FIG. 2

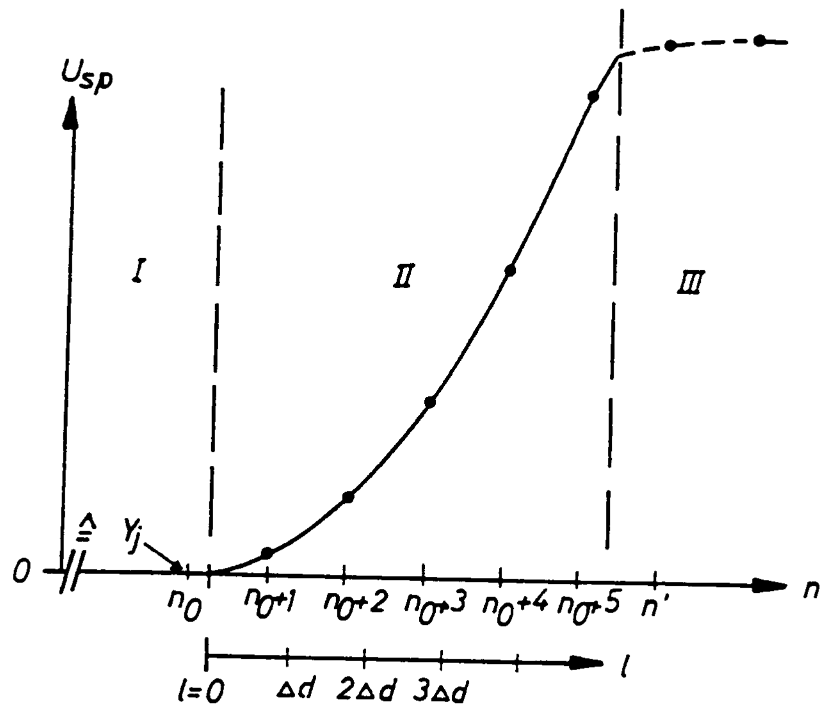

$U_{sp}$
I
II
III
0
$\hat{=}$ $Y_j$
$n_0$
$n_0+1$
$n_0+2$
$n_0+3$
$n_0+4$
$n_0+5$
n'
n
l=0
Δd
2Δd
3Δd
l


FIG. 3

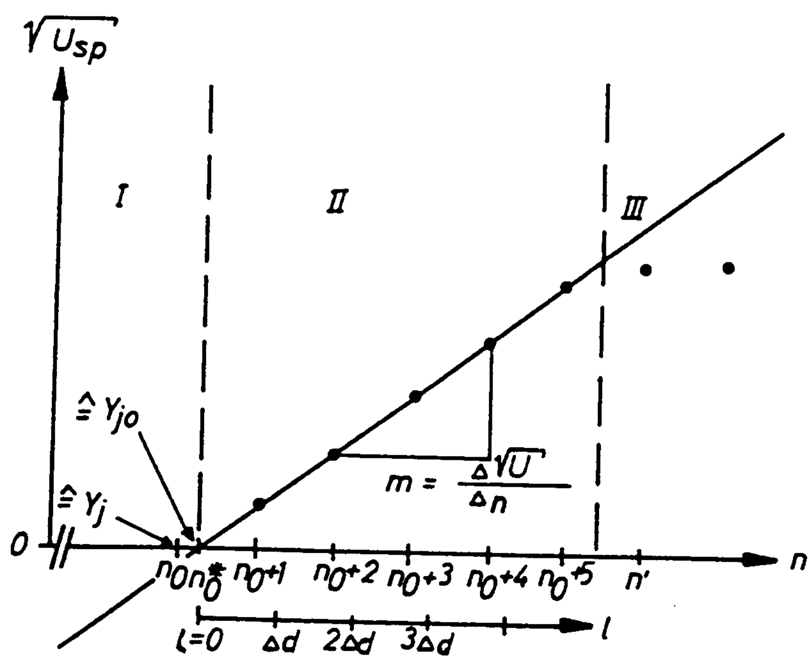

$\sqrt{U_{sp}}$
I
II
III
$\hat{=}$ $Y_{jo}$
$\hat{=}$ $Y_j$
$m = \frac{\Delta\sqrt{U}}{\Delta n}$
0
$n_0$ $n_0^*$
$n_0+1$
$n_0+2$
$n_0+3$
$n_0+4$
$n_0+5$
n'
n
l=0
Δd
2Δd
3Δd
l


FIG. 4